# EUROPEAN PATENT APPLICATION

(11) **EP 4 847 294 A1**
(43) Date of publication of application: **02.12.2026**
(21) Application number: 26181446.1
(22) Date of filing: 27.05.2026
(51) Int. Cl.: B60L 3/00, B60L 3/04, B60L 53/14, B60L 53/62, B60L 55/00, G01R 31/52

(54) **BIDIRECTIONAL CIRCUIT PROTECTION IN ELECTRIC VEHICLE POWER TRANSFER SYSTEMS**

(30) Priority: 27.05.2025 US 202519219828
(71) Applicant: Schneider Electric USA, Inc., Boston, MA 02108 (US)
(72) Inventor: GAO, Zhi, Morrisville, 27560 (US); REID, Paul Andrew, Cedar Rapids, 52404 (US)
(74) Representative: Openshaw & Co.

(57) **Abstract**

The techniques described herein relate to systems, apparatus, articles of manufacture, and methods for bidirectional circuit protection in electric vehicle power transfer systems. An example method includes, using circuitry to perform, determining a direction of charger current flowing through the bidirectional charging circuit coupled to a battery of a vehicle. The method includes generating at least one polarized differential current signal using the determined direction of the charger current to modify a differential current signal representing a leakage current of the bidirectional charging circuit. The method further includes generating a differential charging current signal and/or a differential discharging current signal using the at least one polarized differential current signal. The method additionally includes outputting a differential current protection signal to interrupt the charger current in response to the differential charging current signal and/or the differential discharging current signal satisfying at least one threshold.

## Description

### FIELD

The techniques described herein relate generally to electric vehicles and, more particularly, to methods and apparatus for bidirectional circuit protection in electric vehicle power transfer systems.

### BACKGROUND

An electric vehicle power transfer system (EVPTS) charges an electric vehicle using power from an alternating current (AC) power source, such as a utility electric grid. The EVPTS may include a charging circuit interrupting device (CCID) to monitor the differential current among the current-carrying line conductors in a grounded system and interrupt the circuit for safety when a ground fault condition is detected.

### SUMMARY

In accordance with the disclosed subject matter, systems, apparatus, articles of manufacture, and methods are provided for bidirectional circuit protection in electric vehicle power transfer systems. The disclosed subject matter provides for selecting among different ground fault protection thresholds depending on a detected direction of current flowing through a bidirectional charging circuit. In response to at least one ground fault protection threshold being satisfied, current flowing through the bidirectional charging circuit is interrupted for enhanced safety.

Some embodiments relate to a method for bidirectional ground fault protection in a bidirectional charging circuit for charging and/or discharging a battery of a vehicle. The method comprises, using circuitry to perform, determining a direction of charger current flowing through the bidirectional charging circuit coupled to the battery of the vehicle, generating at least one polarized differential current signal using the determined direction of the charger current to modify a differential current signal representing a leakage current of the bidirectional charging circuit, generating a differential charging current signal and/or a differential discharging current signal using the at least one polarized differential current signal, and outputting a differential current protection signal to interrupt the charger current in response to the differential charging current signal and/or the differential discharging current signal satisfying at least one threshold.

Some embodiments relate to at least one computer-readable storage medium storing processor executable instructions that, when executed by at least one hardware processor, cause the at least one hardware processor to perform a method for bidirectional differential current protection in a bidirectional charging circuit for charging and/or discharging a battery of a vehicle. The method comprises determining a direction of charger current flowing through the bidirectional charging circuit coupled to the battery of the vehicle, generating at least one polarized differential current signal using the determined direction of the charger current to modify a differential current signal representing a leakage current of the bidirectional charging circuit, generating a differential charging current signal and/or a differential discharging current signal using the at least one polarized differential current signal, and outputting a differential current protection signal to interrupt the charger current in response to the differential charging current signal and/or the differential discharging current signal satisfying at least one threshold.

Some embodiments relate to a bidirectional charging system for charging and/or discharging a battery of a vehicle. The bidirectional charging system comprises a differential current sensor configured to measure a differential current signal associated with charging and/or discharging the battery of the vehicle, and bidirectional charging circuitry coupled to the differential current sensor. The bidirectional charging circuitry is configured to determine a direction of charger current flowing through the bidirectional charging circuitry coupled to the battery of the vehicle, generate at least one polarized differential current signal using the determined direction of the charger current to modify a differential current signal representing a leakage current of the bidirectional charging circuit, generate a differential charging current signal and/or a differential discharging current signal using the at least one polarized differential current signal, and output a differential current protection signal to interrupt the charger current in response to the differential charging current signal and/or the differential discharging current signal satisfying at least one threshold.

The foregoing summary is not intended to be limiting. Moreover, various aspects of the present disclosure may be implemented alone or in combination with other aspects.

### BRIEF DESCRIPTION OF FIGURES

Various aspects and embodiments of the present technology will be described with reference to the following figures. It should be appreciated that the figures are not necessarily drawn to scale. Items appearing in multiple figures are indicated by the same or a similar reference number in all the figures in which they appear.
FIG. 1 shows an example bidirectional charging system coupled to an electric vehicle and including a bidirectional charging circuit configured to provide bidirectional charging to the electric vehicle with bidirectional ground fault detection and protection, in accordance with some embodiments of the technology described herein.
FIG. 2 shows an example implementation of a portion of the bidirectional charging circuit of FIG. 1, in accordance with some embodiments of the technology described herein.
FIG. 3A shows an example implementation of a first digital filter of a current direction determination module of the bidirectional charging circuit of FIG. 2, in accordance with some embodiments of the technology described herein.
FIG. 3B shows an example implementation of a second digital filter of the current direction determination module of the bidirectional charging circuit of FIG. 2, in accordance with some embodiments of the technology described herein.
FIG. 4 shows an example implementation of a differential current protection module of the bidirectional charging circuit of FIG. 2, in accordance with some embodiments of the technology described herein.
FIG. 5 is a flowchart representative of an example process that may be performed and/or implemented using hardware logic or machine-readable instructions that may be executed by processor circuitry to implement the bidirectional charging circuit of FIGS. 1 and/or 2 and/or, more generally, the bidirectional charging system of FIG. 1, to monitor the bidirectional charging circuit for a ground fault condition, in accordance with some embodiments of the technology described herein.
FIG. 6 is an example electronic platform structured to implement the hardware logic and/or execute the machine-readable instructions of FIG. 5 to implement the bidirectional charging circuit of FIGS. 1 and/or 2 and/or, more generally, the bidirectional charging system of FIG. 1, in accordance with some embodiments of the technology described herein.

### DETAILED DESCRIPTION

The present disclosure generally provides techniques for bidirectional ground fault protection of a bidirectional charging circuit, which can be configured to provide power to or output power from a rechargeable battery. Example use cases for the present disclosure include power conversion (e.g., an alternating current (AC) to direct current (DC) power conversion system, a DC/AC power conversion system) and EV charging, such as charging and/or discharging power from at least one battery of an electric vehicle (EV).

The techniques involve detecting whether the bidirectional charging circuit is operating in a charging mode or a discharging mode. The charging mode can correspond to an external power source charging a battery of the EV. The discharging mode can correspond to discharging power from the EV to power an external load. To detect the charging/discharging mode, the techniques involve determining directionality of the current flowing through the bidirectional charging circuit. Beneficially, the techniques involve selecting from among different ground fault protection limits depending on which mode is detected to achieve enhanced configurability and operational safety of the circuit in a bidirectional manner.

The present disclosure is applicable to a power transfer system, such as an electric vehicle power transfer system (EVPTS). An EVPTS may be used to supply power from an AC source, such as a utility electric grid, to charge a power source of an EV, such as one or more rechargeable batteries. The EVPTS may include a charging circuit and a charging circuit interrupting device (CCID). The CCID may continuously monitor the differential current among all current-carrying line conductors in the charging circuit and rapidly interrupt the charging circuit under conditions where the differential current exceeds a pre-determined value. Such conditions may be referred to herein as "differential current conditions", "ground fault conditions", or "earth leakage conditions", and all these terms are interchangeable. Detection and protection of these conditions may be referred to as "differential current condition detection and/or protection", "ground fault condition detection and/or protection", or "earth leakage condition detection and/or protection", and all these terms are interchangeable.

The pre-determined value may be a differential current protection threshold (e.g., a differential current protection limit) corresponding to an electrical characteristic at or above which indicates that a ground fault condition is present. A ground fault condition may also be referred to as an "earth leakage condition". Presence of a ground fault condition may indicate that a leakage current and/or a charger current associated with the EVPTS has met and/or exceeded safe operation limits. The differential current protection threshold may also be referred to herein as a "trip current limit," "trip current rating," "differential trip current limit," "differential trip current rating," "ground fault limit," "ground fault protection limit," "ground fault threshold," "ground fault protection threshold," "ground fault rating," "ground fault protection rating", "earth leakage limit," "earth leakage protection limit," "earth leakage threshold," or "earth leakage protection threshold," and all these terms are interchangeable.

CCIDs may be regulated by safety standard(s), such as those established by the Underwriters Laboratories (UL) for the United States of America. For example, CCIDs can be configured in accordance with the UL standards to provide protection against electrical leakage (e.g., ground faults) in EV charging stations for residential or commercial use. In such an example, CCIDs are configured to trigger on AC current. Additionally and/or alternatively, the CCIDs may be configured to trigger on a DC component. CCIDs can be configured with relatively low differential trip current ratings to ensure rapid interruption of ground faults to minimize the risk of electric shock to users (e.g., human persons).

CCIDs may be identified by the letters CCID followed by the differential trip current rating. By way of example, for an electric utility that operates at a nominal utility voltage frequency (e.g., a reference utility voltage frequency) of 60 Hertz (Hz), CCID5 indicates a CCID configured with a nominal differential trip current rating of 5 milliamperes (mA). Similarly, CCID20 indicates a CCID configured with a nominal differential trip current rating of 20 mA at 60 Hz. EV charging applications may use CCID20 (instead of CCID5) when additional safety measures are used in connection with the EVPTS, such as when an additional ground check circuit is installed to monitor for ground wire integrity.

The inventors have recognized a technological challenge with conventional EVPTS related to an EVPTS utilizing the same differential trip current rating for all modes of operation. For example, an EVPTS can trip at 20 mA (e.g., by using CCID20) when configured in a charging mode. EVPTS also trips at 20 mA when configured in a discharging mode. The inventors have recognized that different modes of operation (e.g., charging, discharging) can benefit from having different differential trip current ratings. Advantageously, the inventors have recognized the benefit of selecting a higher differential trip current rating (e.g., 20 mA) when the EVPTS is in the charging mode due to increased sizes of current used for EV charging. Similarly, the inventors have recognized the benefit of selecting a lower differential trip current rating (e.g., 5 mA) when the EVPTS is in the discharging mode due to for personnel protection.

The inventors have developed technology that overcomes this technological challenge. The technology involves a bidirectional charging system that can, in some embodiments, implement a bidirectional EVPTS. The system can detect whether the system is in a charging mode or a discharging mode. The system can detect the operational mode by determining directionality of current flowing through a bidirectional charging circuit of the system.

After determining current directionality, the system can generate a polarized differential current signal using the determined direction of the current to modify a differential current signal representing a leakage current of the bidirectional charging circuit. The system can generate (i) a differential charging current signal corresponding to a charging current and/or (ii) a differential discharging current signal corresponding to a discharging current using the polarized differential current signal.

The system can interrupt the bidirectional charging circuit when a ground fault condition is detected. For example, the system can compare the differential charging/discharging current signals to different, respective thresholds. In such an example, the system can compare the differential charging current signal to at least a first magnitude threshold. The system can compare the differential discharging current signal to at least a second magnitude threshold. The first magnitude threshold can be 20 mA to implement CCID20 and the second magnitude threshold can be 5 mA to implement CCID5. Alternatively, different magnitude threshold values may be used for the first magnitude threshold and/or the second magnitude threshold. In response to at least one threshold being met and/or exceeded, the system can output a differential current protection signal to interrupt the current to achieve enhanced safety when operating the bidirectional charging circuit in either the charging or discharging mode.

Beneficially, the system can overcome the aforementioned technological challenge by dynamically applying an optimal threshold for ground fault detection and protection based on determining whether the system is in a charging mode or a discharging mode. For example, the system can apply a higher ground fault protection limit (e.g., a 20 mA magnitude threshold) when in the charging mode and apply a lower ground fault protection limit (e.g., a 5 mA magnitude threshold) when in the discharging mode to achieve enhanced safety in either mode of operation. Further, the system can provide robust bidirectional ground fault detection and protection against power system harmonics and power system transients, such as voltage sags or swells.

The techniques described herein may be implemented in any of numerous ways, as the techniques are not limited to any particular manner of implementation. Examples of details of implementation are provided herein solely for illustrative purposes. Furthermore, the techniques disclosed herein may be used individually or in any suitable combination, as aspects of the technology described herein are not limited to the use of any particular technique or combination of techniques.

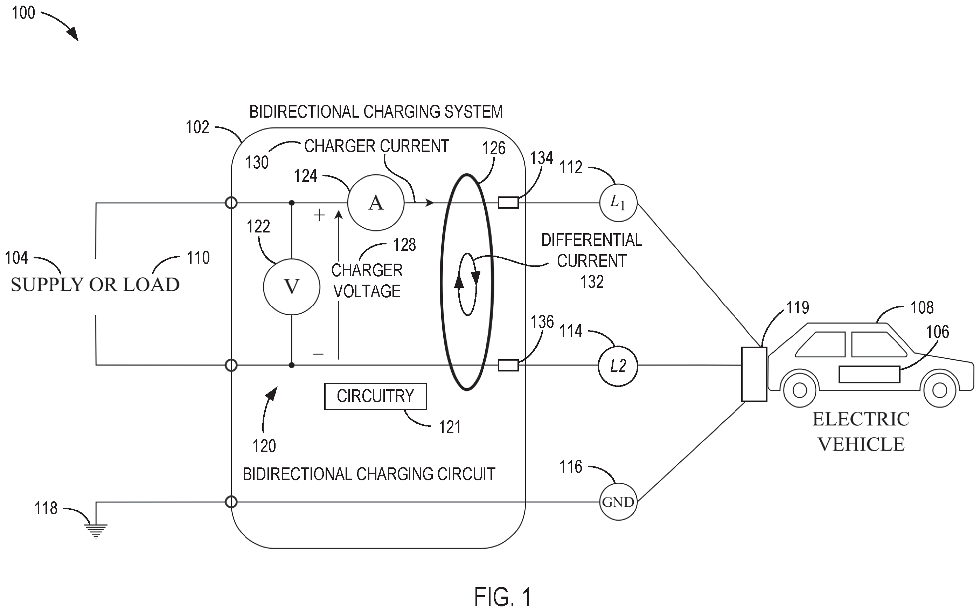

Turning to the figures, the illustrated example of FIG. 1 is a bidirectional charging environment 100 including a bidirectional charging system 102. The bidirectional charging system 102 can be configured to provide power from a supply 104 to charge at least one battery 106 of an electric vehicle 108. The bidirectional charging system 102 can be configured to discharge power from the at least one battery 106 to a load 110 external to the electric vehicle 108.

In some embodiments, the bidirectional charging system 102 implements an electric vehicle power transfer system (EVPTS), such as a bidirectional EVPTS. In some such embodiments, the bidirectional charging system 102 can provide bidirectional charging capabilities in accordance with one more electrical safety standards, such as those established by the Underwriters Laboratories (UL).

The bidirectional charging system 102 is bidirectional because it can be configured to operate in a charging mode or a discharging mode. The charging mode corresponds to the bidirectional charging system 102 charging the battery 106 via the supply 104. The discharging mode corresponds to the bidirectional charging system 102 powering the load 110 via the battery 106.

In some embodiments, the bidirectional charging system 102 can switch between modes automatically and/or dynamically without user intervention. For example, the bidirectional charging system 102 can switch from the charging mode to the discharging mode when there is a power outage and supply 104 is absent. In another example, the bidirectional charging system 102 can switch from the discharging mode to the charging mode when the power is restored and supply 104 is available.

The electric vehicle 108 is a vehicle powered entirely or at least in part by the at least one battery 106. Examples of the electric vehicle 108 include a battery electric vehicle, a plug-in hybrid electric vehicle, and a hybrid electric vehicle.

The at least one battery 106 can include a plurality of batteries. Examples of the at least one battery 106 include lithium-ion batteries (e.g., lithium-ion (NMC) batteries, lithium-iron phosphate (LFP) batteries), nickel-metal hydride (NiMH) batteries, solid-state batteries, and sodium-ion batteries.

The electric vehicle 108 shown is a land vehicle. Examples of a land vehicle include an all-terrain vehicle, a bus, a construction vehicle, an electrified cart, a sedan, a motorcycle, a sports utility vehicle, a truck, and a van. Alternatively, the electric vehicle 108 may be a marine vehicle (e.g., a boat, a ship) or an aerial vehicle (e.g., a drone, a human piloted aircraft).

The bidirectional charging system 102 implements alternating current (AC) power delivery to the battery 106 in a first direction (e.g., in a charging mode) or the load 110 in a second direction (e.g., in a discharging mode). For example, the AC power delivery can include delivering a nominal AC power voltage of 240 Volts AC (VAC) at 60 Hz. In such an example, the AC power delivery can include delivering AC power at a voltage in a voltage range from 208 to 252 VAC at 60 Hz. Alternatively, the AC power delivery can be delivered using a different nominal AC power voltage and/or frequency, such as 230 VAC at 50 Hz. In such an example, the AC power delivery can include delivering AC power at a voltage in a voltage range from 220 to 240 VAC at 50 Hz.

As shown, the bidirectional charging system 102 includes a first connection 112 (identified by "L₁"), a second connection 114 (identified by "L₂"), and a third connection 116. The first connection 112 is a first line connection (e.g., a first AC line input). The second connection 114 can be a second line connection (e.g., a second AC line input). Alternatively, the second connection 114 may be a neutral connection (e.g., an AC neutral input). The third connection 116 is a ground connection coupled to electrical ground 118. Electrical ground 118 can be physical earth ground. The first connection 112, the second connection 114, and/or the third connection 116 can be respectively implemented by one or more electrical wires and/or one or more electrical cables.

In some embodiments, the connections 112, 114, 116 are coupled to the electric vehicle 108 via a charging coupler interface 119. The charger coupler interface 119 can be an electric vehicle charging connector (e.g., a plug) designed, configured, and/or manufactured in accordance with one or more standards. Example standards include Society of Automotive Engineers (SAE) standard J1772 and J3400.

As shown, the bidirectional charging system 102 includes a bidirectional charging circuit 120 configured to effectuate bidirectional charging with bidirectional ground fault detection and protection. The bidirectional charging circuit 120 can include the connections 112, 114, 116, circuitry 121, a voltage sensor 122, a current sensor 124, and a differential current sensor 126. The circuitry 121 can be coupled (e.g., electrically coupled) to at least one of the connections 112, 114, 116, the voltage sensor 122, the current sensor 124, or the differential current sensor 126.

The voltage sensor 122 can be configured to measure a charger voltage 128. The charger voltage 128 can correspond to a voltage used to charge the battery 106 or provide power to the load 110. The charger voltage 128 is a voltage of the first connection 112 with respect to the second connection 114.

Examples of the voltage sensor 122 include capacitive, resistive, and inductive voltage sensors. Examples of capacitive voltage sensors include capacitive voltage dividers. Examples of resistive voltage sensors include bridge circuits and voltage divider circuits. Examples of inductive voltage sensors include transformers (e.g., potential transformers).

The current sensor 124 can be configured to measure a charger current 130. The charger current 130 can correspond to a current used to charge the battery 106 or provide power to the load 110. The charger current 130 is a current flowing through the first connection 112. Examples of the current sensor 124 include a current transformer (CT), a Rogowski coil, and a shunt resistor.

The differential current sensor 126 can be configured to measure a differential current 132. The differential current 132 can correspond to a leakage current when the bidirectional charging system 102 is in the charging or discharging mode. The differential current 132 is a different in electrical current flowing through the first connection 112 and the second connection 114. Examples of the differential current sensor 126 include a CT, a Rogowski coil, and the use of multiple shunt resistors.

In some embodiments, one or more portions of the bidirectional charging system 102 can implement a CCID. For example, the circuitry 121, the voltage sensor 122, the current sensor 124, the differential current sensor 126 and/or, more generally, the bidirectional charging circuit 120 can implement a CCID.

By way of example, the differential current sensor 126 can sense and/or measure the differential current 132. The differential current 132 can be sampled, using the circuitry 121, to generate differential current samples in a discrete-time system from the current-carrying line conductors L₁ 112 and L₂ 114.

In some embodiments, the circuitry 121 is control circuitry or logic circuitry. In some embodiments, the circuitry 121 can be implemented by one or more analog circuits (e.g., analog-to-digital converters (ADCs), capacitors, comparators, diodes, inductors, operational amplifiers, resistors, transistors, etc.), one or more digital circuits (e.g., logic gates, etc.), one or more hardware-implemented state machines, one or more programmable processors, one or more application specific integrated circuits (ASICs), etc., and/or any combination(s) thereof. Examples of the programmable processors include central processing units (CPUs), digital signal processors (DSPs), field programmable gate arrays (FPGAs), and microcontrollers.

Furthering the example, the voltage sensor 122 can sense and/or measure the charger voltage 128. The charger voltage 128 can be sampled, using the circuitry 121, to generate a voltage sample in a discrete-time system. The current sensor 124 can also sense and/or measure the charger current 130. The charger current 130 can be sampled, using the circuitry 121, to generate a current sample in a discrete-time system.

Continuing the example, the circuitry 121 can process the differential current samples, the voltage samples, and the current samples into a determination of whether a ground fault condition is detected. For example, when in the charging mode, the circuitry 121 can be configured to output a differential current protection signal to a first switch 134 and/or a second switch 136 to trip and/or otherwise interrupt the charger current 130 flowing to the electric vehicle 108 at a nominal differential trip current rating of 20 mA. The differential current protection signal can cause the first switch 134 and/or the second switch 136 to open to interrupt the charger current 130.

When in the discharging mode, the circuitry 121 can be configured to output the differential current protection signal to the first switch 134 and/or the second switch 136 to trip and/or otherwise interrupt the charger current 130 flowing to the load 110 at a nominal differential trip current rating of 5 mA. The differential current protection signal can cause the switch 134 and/or the second switch 136 to open to interrupt the charger current 130. Beneficially, the bidirectional charging circuit 120 can select from among different differential trip current ratings depending on the direction of the charger current 130 to achieve enhanced safety (e.g., personnel protection).

As shown, the first switch 134 is in circuit with the first line input 112 such that the first switch 134 can open to interrupt the charger current 130 flowing through the first line input 112. As shown, the second switch 136 is in circuit with the second line input 114 such that the second switch 136 can open to interrupt the charger current 130 flowing through the second line input 114.

Examples of the first switch 134 and the second switch 136 include a relay (e.g., single pole relays, a double pole relay) and a transistor. Examples of the relay include electromechanical relays, latching relays, and solid state relays. Examples of the transistor include a bipolar junction transistor (BJT), a field-effect transistor (FET), and an insulated gate bipolar transistor (IGBT). Examples of a FET include a junction field effect transistor (JFET), a power FET, and a metal-oxide-semiconductor field-effect transistor (MOSFET).

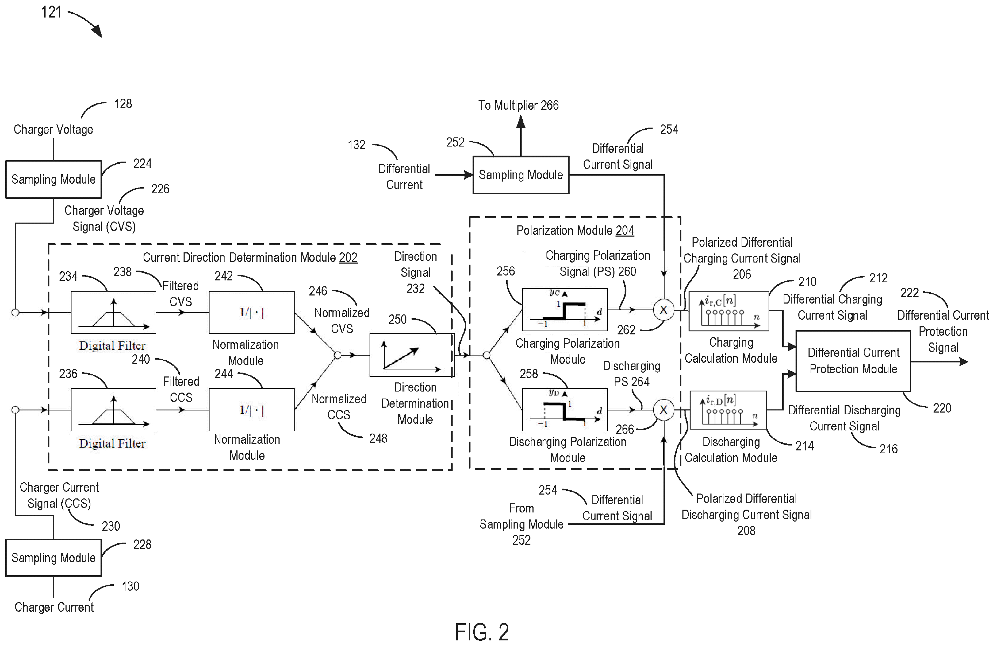

FIG. 2 shows an example implementation of a portion of the bidirectional charging circuitry 120 of FIG. 1, which includes the circuitry 121 of FIG. 1. The circuitry 121 includes a current direction determination module 202 configured to determine a direction of the charger current 130 flowing through the bidirectional charging circuit 120 coupled to the battery 106 of the electric vehicle 108 of FIG. 1. The circuitry 121 includes a polarization module 204 configured to generate at least one polarized differential current signal 206, 208 using the determined direction of the charger current 130 to modify a differential current signal 254 corresponding to and/or representing a leakage current of the bidirectional charging circuit 120. The circuitry 120 includes a charging calculation module 210 configured to generate a differential charging current signal 212 and a discharging calculation module 214 configured to generate a differential discharging current signal 216 using the at least one polarized differential current signal 206, 208. The circuitry 121 further includes a differential current protection module 220 configured to output a differential current protection signal 222 to interrupt the charger current 130 in response to the differential charging current signal 212 and/or the differential discharging current signal 216 satisfying at least one threshold.

The circuitry 121 can be configured to receive the charger voltage 128 of FIG. 1. The circuitry 121 includes a first sampling module 224 configured to sample the charger voltage 128, which is an analog signal, into a charger voltage signal (CVS) 226, which is a digital signal. The CVS 226 can include one or more samples (e.g., digital samples) of the charger voltage 128.

The circuitry 121 can be configured to receive the charger current 130 of FIG. 1. The circuitry 121 includes a second sampling module 228 configured to sample the charger current 130, which is an analog signal, into a charger current signal (CCS) 230, which is a digital signal. The CCS 230 can include one or more samples (e.g., digital samples) of the charger current 130.

The current direction determination module 202 receives inputs and generates a current flow direction signal 232 (or current flow directional signal) as output. The inputs include the CVS 226, the CCS 230, and/or a nominal utility voltage frequency (e.g., 50 Hz, 60 Hz). The current flow direction signal 232 indicates a direction of the charger current 130.

In some embodiments, the current direction determination module 202 can be implemented by hardware alone, such as being implemented by one or more analog circuits (e.g., current direction determination circuitry). In some embodiments, the current direction determination module 202 can be implemented by a combination of hardware, software, and/or firmware. For example, the current direction determination module 202 can be implemented by an ASIC and/or at least one programmable processor (e.g., a DSP, a microcontroller).

Measurements of voltage and current samples from the bidirectional charging system 102, when not filtered, often contain power system harmonics and are subject to power system transients, such as voltage sags or swells. The inventors have recognized that digital filters can remove such power system harmonics and transients, and are shown as a first digital filter 234 and a second digital filter 236. As shown, the first digital filter 234 filters the CVS 226 into the filtered CVS 238. The second digital filter 236 filters the CCS 230 into the filtered CCS 240.

In some embodiments, the first digital filter 234 and/or the second digital filter 236 are respectively implemented by a programmable processor (e.g., a DSP, a microcontroller). Alternatively, the first digital filter 234 and/or the second digital filter 236 may be implemented by one or more analog circuits (e.g., a filter circuit).

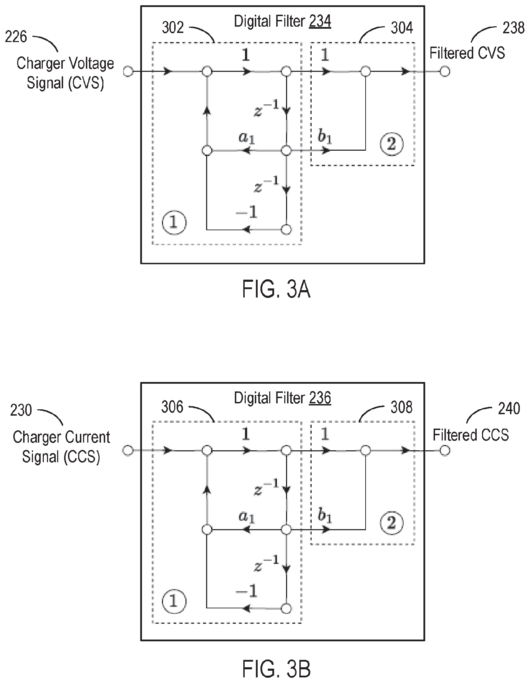

In some embodiments, the first digital filter 234 and the second digital filter 236 each implement a harmonic estimator that can use the Goertzel technique to efficiently extract harmonic components at the nominal utility voltage frequency for ground fault protection (e.g., differential current protection) purposes. Example implementations for the first digital filter 234 and the second digital filter 236 are shown in FIGS. 3A and 3B, respectively.

Turning to FIG. 3A, which shows an example implementation of the first digital filter 234 of FIG. 2, and FIG. 3B, which shows an example implementation of the second digital filter 236 of FIG. 2, each harmonic estimator has a transfer function in the discreate-time domain. The transfer function is shown in Equation (1) below:
$H \left(z\right) = \frac{1 + {b}_{1} {z}^{- 1}}{1 + {a}_{1} {z}^{- 1} + {z}^{- 2}} ,$ Equation (1)

To extract the harmonic component at the nominal utility voltage frequency,
${b}_{1} = - exp \left(-j2π {f}_{e}/{f}_{S}\right) ,$ and${a}_{1} = - 2 cos \left(2π {f}_{e}/{f}_{S}\right) ,$where *f*ₑ is the nominal utility voltage frequency, and *f*_{S} is the sampling frequency.

As shown in the signal flow graph of FIG. 3A, the first digital filter 234 can implement a first harmonic estimator that extracts a voltage component at the nominal utility voltage frequency from the CVS 226. For example, the first harmonic estimator can be a voltage harmonic estimator configured to extract a voltage component at the nominal utility voltage frequency from the CVS 226. The extracted voltage component is shown as the filtered CVS 238.

As shown in the signal flow graph of FIG. 3B, the second digital filter 236 can implement a second harmonic estimator that extracts a current component at the nominal utility voltage frequency from the CCS 230. For example, the second harmonic estimator can be a current harmonic estimator configured to extract a current component at the nominal utility voltage frequency from the CCS 230. The extracted current component is shown as the filtered CCS 240.

In FIGS. 3A-3B, each digital filter 234, 236 includes a first loop 302, 306 to be executed first. Once the first loop 302, 306 is completed, its output is fed into a corresponding second loop 304, 308. The complex multiplication by *b*₁, which is performed to implement the zero of the transfer function in Equation (1) above, may only need to be executed once.

In some embodiments, while the CVS 226 and the CCS 230 are real signals, the outputs of the harmonic estimators, the filtered CVS 238 and the filtered CCS 240, are complex signals. The voltage and current components, the filtered CVS 238 and the filtered CCS 240, contain both the amplitude and phase information of the CVS 226 and the CCS 230, respectively.

Returning to FIG. 2, the current direction determination module 202 includes a first normalization module 242 and a second normalization module 244. The first normalization module 242 can be configured to receive the filtered CVS 238 as input and generate a normalized CVS 246 as output. The normalized CVS 246 is a normalized voltage signal having a unitary amplitude.

The first normalization module 242 can be configured to obtain the amplitude of the filtered CVS 238 by taking the modulus of the filtered CVS 238, |*Filtered CVS*|, where |·| denotes the modulus of a complex number. The first normalization module 242 can be configured to then scale the filtered CVS 238 by 1/|*Filtered CVS*|, and generate the normalized CVS 246 as output.

The second normalization module 244 can be configured to receive the filtered CCS 240 as input and generate a normalized CCS 248 as output. The normalized CCS 248 is a normalized current signal having a unitary amplitude.

The second normalization module 244 can be configured to obtain the amplitude of the filtered CCS 240 by taking the modulus of the filtered CCS 240, |*Filtered CCS*|, where |·| denotes the modulus of a complex number. The second normalization module 244 can be configured to then scale the filtered CCS 240 by 1/|*Filtered CCS*|, and generate the normalized CCS 248 as output.

The current direction determination module 202 includes a direction determination module 250 configured to determine whether the direction of the charger current 130 is in or out of phase with respect to the charger voltage 128. The direction determination module 250 can carry out this determination by calculating the current flow direction signal 232 (denoted by *d*ₑ in Equation (2) below) from the normalized CVS 246 (identified by norm CVS in Equation (2) below) and the normalized CCS 248 (identified by norm CCS in Equation (2) below) in accordance with Equation (2) below:${d}_{e} = real \left(norm CVS\right) ⋅ real \left(norm CCS\right) + imag \left(norm CVS\right) ⋅ imag \left(normCCS\right) ,$ Equation (2) *,* Equation (2), where real(·) denotes the real part of a complex signal, and imag(·) denotes the imaginary part of a complex signal.

Because both the normalized CVS 246 and the normalized CCS 248 have unitary amplitudes, the current flow direction signal 232 is a real signal with a magnitude between -1 and 1. When the charger current 130 flow is within (-90°, 90°) phase angle with respect to the charger voltage 128 (leading or lagging), the current flow direction signal 232 calculated from Equation (2) has a magnitude between 0 and 1. This is generally associated with the bidirectional charging system 102 operating in the charging mode. For example, the direction determination module 250, the current direction determination module 202, and/or, more generally, the circuitry 121, can detect that the bidirectional charging system 102 is operating in the charging mode when the current flow direction signal 232 has a magnitude between 0 and 1. In such an example, the bidirectional charging system 102 operating in the charging mode is detected using the direction of the charger current 130.

When the charger current 130 flow is out of phase (e.g., within 90°, 270°) with respect to the charger voltage 128, the current flow direction signal 232 calculated from Equation (2) has a magnitude between -1 and 0. This is generally associated with the bidirectional charging system 102 operating in the discharging mode. For example, the direction determination module 250, the current direction determination module 202, and/or, more generally, the circuitry 121, can detect that the bidirectional charging system 102 is operating in the discharging mode when the current flow direction signal 232 has a magnitude between -1 and 0. In such an example, the bidirectional charging system 102 operating in the discharging mode is detected using the direction of the charger current 130.

In some embodiments, the circuitry 121 can execute continuous determinations of the phase difference between the charger voltage 128 and the charger current 130 to determine the reactance of the differential current path, which can be used to change a differential current protection threshold. For example, larger phase differences may be used to reduce (e.g., dynamically reduce) a magnitude and/or time threshold to trip the differential current protection. In another example, smaller phase differences may be used to increase (e.g., dynamically increase) a magnitude and/or time threshold to trip the differential current protection.

To effectuate ground fault protection, the circuitry 121 includes a third sampling module 252 configured to sample the differential current 132 of FIG. 1, which is an analog signal, into a differential current signal 254, which is a digital signal. The differential current signal 254 can include one or more samples (e.g., digital samples) of the differential current 132.

The first sampling module 224, the second sampling module 228, and/or the third sampling module 252 can be implemented by hardware alone. For example, one(s) of the sampling modules 224, 228, 252 can be respectively implemented by sampling circuitry, such as an ADC. In another example, one(s) of the sampling modules 224, 228, 252 can be respectively implemented by a combination of hardware, software, and/or firmware. For example, one(s) of the sampling modules 224, 228, 252 can be implemented by an ASIC and/or a programmable processor (e.g., a DSP, a microcontroller).

The polarization module 204 can be configured to receive the direction signal 232 and the differential current signal 254 as input to generate polarized differential current signals 206, 208 as output. As shown, the polarization module 204 applies the direction signal 232 to the differential current signal 254 after passing the direction signal 232 separately through a charging polarization module 256 or a discharging polarization module 258. For example, the polarization module 204 can generate the polarized differential charging current signal 206 and/or the polarized differential discharging current signal 208 by using the differential current signal 254 and the direction signal 232.

In some embodiments, the polarization module 204 can be implemented by hardware alone, such as being implemented by one or more analog circuits (e.g., polarization circuitry). In some embodiments, the polarization module 204 can be implemented by a combination of hardware, software, and/or firmware. For example, the polarization module 204 can be implemented by an ASIC and/or at least one programmable processor (e.g., a DSP, a microcontroller).

The charging polarization module 256 can be configured to generate a first polarization signal 260. The first polarization signal 260 is a charging polarization signal. The charging polarization module 256 can be configured to generate the first polarization signal 260 (identified by "*y*_{C}" in Equation (3) below) using the direction signal 232 and the logic shown in Equation (3) below:
${y}_{C} = \left\{\begin{matrix}1 & 0 \leq {d}_{e} \leq 1 \\ 0 & - 1 \leq {d}_{e} < 0\end{matrix},\right.$ Equation (3)

The charging polarization module 256 can be configured to multiply, using multiplier 262, the charging polarizing signal 260 with the differential current signal 254 to generate the polarized differential charging current signal 206 at its output.

The discharging polarization module 258 can be configured to generate a second polarization signal 264. The second polarization signal 264 is a discharging polarization signal. The discharging polarization module 258 can be configured to generate the second polarization signal 264 (identified by "*y*_{D}" in Equation (4) below) using the direction signal 232 and the logic shown in Equation (4) below:
${y}_{D} = \left\{\begin{matrix}1 & 0 \leq {d}_{e} \leq 1 \\ 0 & - 1 \leq {d}_{e} < 0\end{matrix},\right.$ Equation (4)

The discharging polarization module 258 can be configured to multiply, using multiplier 266, the discharging polarizing signal 264 with the differential current signal 254 to generate the polarized differential discharging current signal 208 at its output.

In some embodiments, the charging polarization module 256, the discharging polarization module 258, the first multiplier 262, and/or the second multiplier 266 can be implemented by hardware alone, such as being implemented by one or more analog circuits (e.g., charging polarization circuitry, discharging polarization circuitry, multiplier circuitry). In some embodiments, the charging polarization module 256, the discharging polarization module 258, the first multiplier 262, and/or the second multiplier 266 can be implemented by a combination of hardware, software, and/or firmware. For example, the charging polarization module 256, the discharging polarization module 258, the first multiplier 262, and/or the second multiplier 266 can be implemented by an ASIC and/or at least one programmable processor (e.g., a DSP, a microcontroller).

The charging calculation module 210 can be configured to receive the polarized differential charging current signal 206 as input to generate the differential charging current signal 212 as output. In some embodiments, the charging calculation module 210 can be configured to compute and/or otherwise determine the differential charging current signal 212 from a sequence of samples of the polarized differential charging current signal 206, for example, over a half cycle of the waveform of the differential current 132. The differential charging current signal 212 can represent and/or correspond to the present differential current level when the bidirectional charging system 102 operates in the charging mode.

The discharging calculation module 214 can be configured to receive the polarized differential discharging current signal 208 as input to generate the differential discharging current signal 216 as output. In some embodiments, the discharging calculation module 214 can be configured to compute and/or otherwise determine the differential discharging current signal 216 from a sequence of samples of the polarized differential discharging current signal 208, for example, over a half cycle of the waveform of the differential current 132. The differential discharging current signal 216 can represent and/or correspond to the present differential current level when the bidirectional charging system 102 operates in the discharging mode.

In some embodiments, the charging calculation module 210 and/or the discharging calculation module 214 can be implemented by hardware alone, such as being implemented by one or more analog circuits (e.g., charging calculation circuitry, discharging calculation circuitry). In some embodiments, the charging calculation module 210 and/or the discharging calculation module 214 can be implemented by a combination of hardware, software, and/or firmware. For example, the charging calculation module 210 and/or the discharging calculation module 214 can be implemented by an ASIC and/or at least one programmable processor (e.g., a DSP, a microcontroller).

The circuitry 121 includes the differential current protection module 220 to monitor (e.g., continuously monitor) the differential current 132 and rapidly interrupt flow of the charger current 130 when the differential current 132 meets and/or exceeds a nominal differential trip rating. The nominal differential trip rating can be 20 mA at 60 Hz when the bidirectional charging system 102 is in the charging mode and 5 mA at 60 Hz when in the discharging mode. Alternatively, different nominal differential trip ratings may be used for the charging and/or discharging mode.

In some embodiments, the differential current protection module 220 can be configured to execute and/or implement a varying delay function such that different magnitudes of the differential current 132, even if meeting and/or exceeding a magnitude threshold, may trip with different trip response times. The varying delay function can be implemented by weighted trip curves having trip times depending on the magnitude of the differential current 132. By way of example, a first value of the differential current 132 being slightly greater than a magnitude threshold can take longer to trip than a second value of the differential current 132 being significantly greater than the magnitude threshold.

In some embodiments, the weighted trip curves can be inverse time trip curves such that smaller magnitudes of differential current 132 that exceed a magnitude threshold take longer to trip a ground fault condition than larger magnitudes of differential current 132 that exceed the magnitude threshold. For example, when the differential current protection module 220 implements an inverse time trip curve, it can operate such that the time it takes to trip the differential current protection decreases as the magnitude of the differential current 132 increases.

In some embodiments, the differential current protection module 220 be implemented by hardware alone, such as being implemented by one or more analog circuits (e.g., differential current protection circuitry). In some embodiments, the differential current protection module 220 can be implemented by a combination of hardware, software, and/or firmware. For example, the differential current protection module 220 can be implemented by an ASIC and/or at least one programmable processor (e.g., a DSP, a microcontroller).

The differential current protection module 220 can be configured to receive the differential charging current signal 212 and/or the differential discharging current signal 216 as input(s) to generate the differential current protection signal 222 as output.

In some embodiments, the differential current protection signal 222 is a logic high signal. The logic high signal may be a voltage corresponding to a digital '1'. Examples of the voltage may be 3.3 VDC, 5 VDC, 12 VDC, and 24 VDC.

In some embodiments, the differential current protection signal 222 is a logic low signal. The logic low signal may be a voltage corresponding to a digital '0'. Examples of the voltage may be 0 VDC, 0.3 VDC, and 0.5 VDC.

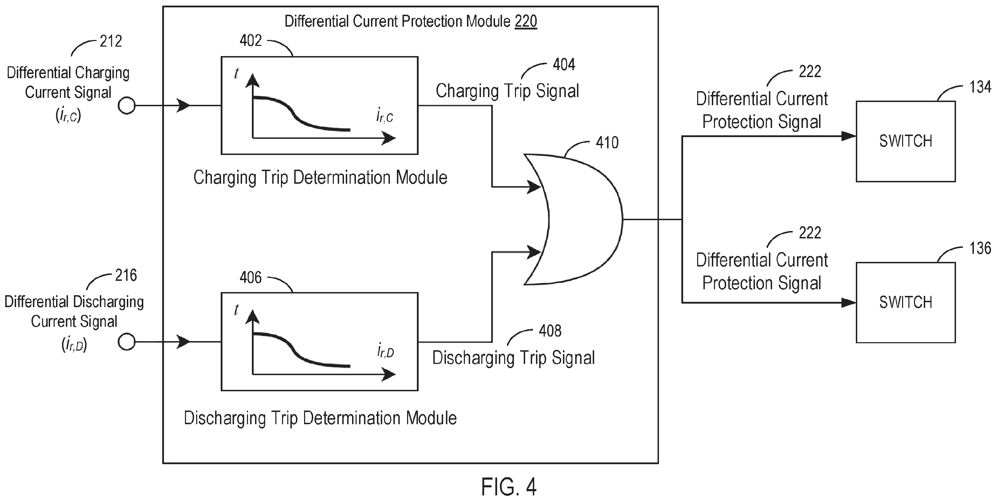

The differential current protection module 220 can be configured to generate the differential current protection signal 222, which can be a trip signal, at its output when the differential current 132 meets and/or exceeds at least one threshold. The at least one threshold can correspond to a nominal differential trip current rating. The bidirectional charging system 102 can use the differential current protection signal 222 to interrupt its operation to provide protection to achieve enhanced safety for users. For example, the differential current protection signal 222 can be output to the first switch 134 and/or the second switch 136 of FIG. 1 to open the first switch 134 and/or the second switch 136 and thereby interrupt flow of the charger current 130 when a ground fault condition is detected. An example implementation of the differential current protection module 220 is shown in FIG. 4.

FIG. 4 shows an example implementation of the differential current protection module 220 of FIG. 2. The differential current protection module 220 can be configured to receive the differential charging current signal 212 and the differential discharging current signal 216 of FIG. 2 as inputs to generate the differential current protection signal 222 as output.

The differential current protection module 220 includes a charging trip determination module 402 configured to monitor the magnitude of the differential charging current signal 212 and the time elapsed since it exceeded a first nominal differential trip current rating (e.g., 20 mA at 60 Hz). The charging trip determination module 402 can generate and/or output a charging trip signal 404 when the trip criteria (e.g., the charging trip criteria) have been met and/or exceeded. In some embodiments, the charging trip determination module 402 implements an inverse time trip curve.

The charging trip criteria can include at least one threshold (e.g., at least one charging trip threshold). The at least one charging trip threshold can include a first magnitude threshold. The first magnitude threshold can be 20 mA (e.g., at 60 Hz). Different examples of the first magnitude threshold include magnitudes of 5 mA and 30 mA, among others. The first magnitude threshold may be in a magnitude range of 16 mA to 20 mA. Alternatively, the first magnitude threshold may correspond to a different nominal utility voltage frequency such as 50 Hz.

Alternatively, the first magnitude threshold may be a first amplitude threshold. For example, the first amplitude threshold can be 20 mA (e.g., at 60 Hz). Different examples of the first amplitude threshold include amplitudes of 5 mA and 30 mA, among others. The first amplitude threshold may be in an amplitude range of 16 mA to 20 mA. Alternatively, the first amplitude threshold may correspond to a different nominal utility voltage frequency such as 50 Hz.

The charging trip determination module 402 can be configured to compare the magnitude of the differential charging current signal 212 to the first magnitude threshold. The charging trip determination module 402 can be configured to output the charging trip signal 404 when the magnitude meets and/or exceeds the first magnitude threshold and thereby satisfies the first magnitude threshold.

The at least one charging trip threshold can include a first elapsed time threshold. The first elapsed time threshold can be 20 milliseconds (ms), 250 ms, 500 ms, 1 second or a different amount of time. The charging trip determination module 402 can be configured to compare (i) an elapsed time since the magnitude (or amplitude) of the differential charging current signal 212 satisfied the first magnitude threshold (or the first amplitude threshold) to (ii) the first elapsed time threshold. The charging trip determination module 402 can be configured to output the charging trip signal 404 when the elapsed time meets and/or exceeds the first elapsed time threshold and thereby satisfies the first elapsed time threshold.

The differential current protection module 220 includes a discharging trip determination module 406 configured to monitor the magnitude of the differential discharging current signal 216 and the time elapsed since it exceeded a second nominal differential trip current rating (e.g., 5 mA at 60 Hz). The discharging trip determination module 406 can generate and/or output a discharging trip signal 408 when the trip criteria (e.g., the discharging trip criteria) have been met and/or exceeded. In some embodiments, the discharging trip determination module 406 implements an inverse time trip curve.

The discharging trip criteria can include at least one threshold (e.g., at least one discharging trip threshold). The at least one discharging trip threshold can include a second magnitude threshold. The second magnitude threshold can be 5 mA (e.g., at 60 Hz). Different examples of the second magnitude threshold include magnitudes of 20 mA and 30 mA, among others. The second magnitude threshold may be in a magnitude range of 4 mA to 6 mA. Alternatively, the second magnitude threshold may correspond to a different nominal utility voltage frequency such as 50 Hz.

Alternatively, the second magnitude threshold may be a second amplitude threshold. For example, the second amplitude threshold can be 5 mA (e.g., at 60 Hz). Different examples of the second amplitude threshold include amplitudes of 20 mA and 30 mA, among others. The second amplitude threshold may be in an amplitude range of 4 mA to 6 mA. Alternatively, the second amplitude threshold may correspond to a different nominal utility voltage frequency such as 50 Hz.

The discharging trip determination module 406 can be configured to compare the magnitude of the differential discharging current signal 216 to the second magnitude threshold. The discharging trip determination module 406 can be configured to output the discharging trip signal 408 when the magnitude meets and/or exceeds the second magnitude threshold and thereby satisfies the second magnitude threshold.

The at least one discharging trip threshold can include a second elapsed time threshold. The second elapsed time threshold can be 20 ms, 250 ms, 500 ms, 1 second or a different amount of time. The discharging trip determination module 406 can be configured to compare (i) an elapsed time since the magnitude (or the amplitude) of the differential discharging current signal 216 satisfied the second magnitude threshold (or the second amplitude threshold) to (ii) the second elapsed time threshold. The discharging trip determination module 406 can be configured to output the discharging trip signal 408 when the elapsed time meets and/or exceeds the second elapsed time threshold and thereby satisfies the second elapsed time threshold.

As shown, the charging trip signal 404 and the discharging trip signal 408 are output to control logic 410, which is implemented in this example as a logical OR gate. For example, when either the charging trip signal 404 indicates a ground fault condition in the charging mode or the discharging trip signal 408 indicates a ground fault condition in the discharging mode, then the control logic 410 outputs the differential current protection signal 222. In such an example, the differential current protection signal 222 can signal to the first switch 134 and/or the second switch 136 that the differential current 132 has exceeded the nominal differential trip current rating of the bidirectional charging system 102 for the corresponding mode (e.g., charging mode, discharging mode). Furthering the example, the differential current protection module 220 can control, with the differential current protection signal 222, the first switch 134 and/or the second switch 136 to interrupt the charger current 130 flowing through the bidirectional charging circuit 120 to achieve comprehensive bidirectional ground fault protection.

In some embodiments, the differential current protection signal 222 can be supplied to a different system. For example, the differential current protection signal 222 can be output to the vehicle 108 of FIG. 1 for diagnostic and/or control purposes. In such an example, the differential current protection signal 222 can be used to trip an electrical protection module of the vehicle 108, such as ground fault protection circuitry and/or overcurrent protection circuitry included in the vehicle 108. In another example, the differential current protection signal 222 can be output to an upstream and/or downstream overcurrent protection device for diagnostic and/or control purposes. In such an example, the differential current protection signal 222 can be used to trip an electrical protection module of an infrastructure, such as ground fault protection circuitry and/or overcurrent protection circuitry of a home residence or commercial business.

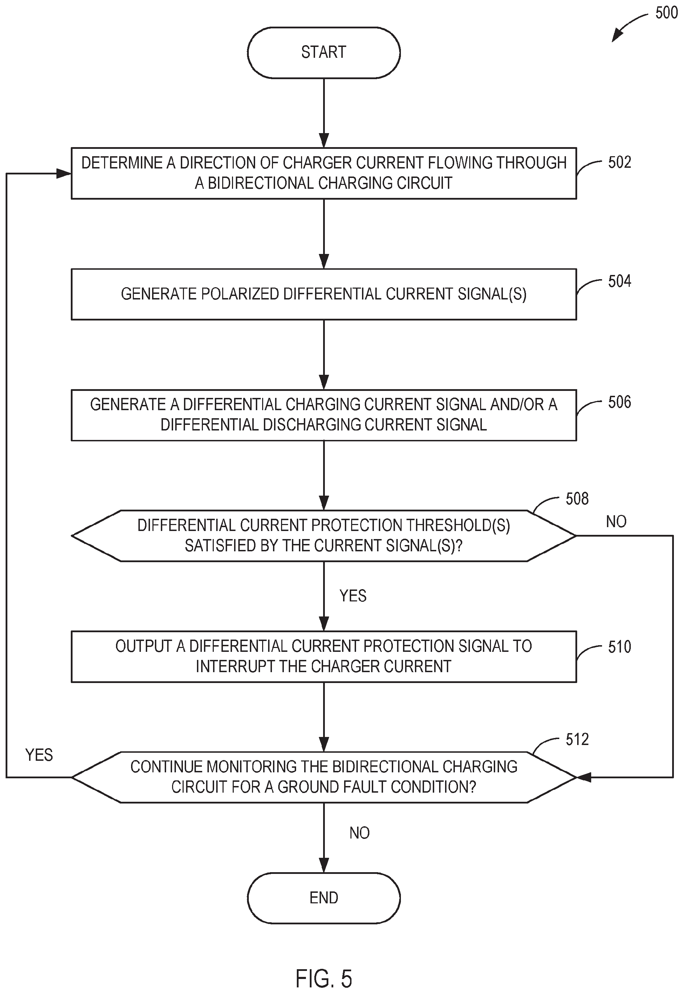

FIG. 5 is a flowchart 500 representative of an example process to be performed and/or example machine-readable instructions that may be executed by processor circuitry. The process and/or execution of the machine-readable instructions can implement the bidirectional charging system 102 of FIG. 1, or portion(s) thereof, such as the circuitry 121 of FIGS. 1 and/or 2. For example, the flowchart 500 in whole or in part can be executed by the circuitry 121 of FIGS. 1 and/or 2. Additionally or alternatively, block(s) of the flowchart 500 may be representative of state(s) of one or more hardware-implemented state machines, algorithm(s) that may be implemented by hardware alone such as an ASIC, etc., and/or any combination(s) thereof.

The flowchart 500 of FIG. 5 begins at block 502, at which the circuitry 121 may determine a direction of charger current flowing through a bidirectional charging circuit. For example, the current direction determination module 202 can determine a direction of the charger current 130 flowing through the bidirectional charging circuit 120 of FIG. 1. In such an example, the current direction determination module 202 can determine, using the direction determination module 250, that the direction, as indicated by the direction signal 232, corresponds to the charger current 130 flowing from the supply 104 to the battery 106 of the electric vehicle 108. In another example, the current direction determination module 202 can determine, using the direction determination module 250, that the direction, as indicated by the direction signal 232, corresponds to the charger current 130 flowing from the battery 106 to the load 110.

At block 504, the circuitry 121 may generate polarized differential current signal(s). For example, the polarization module 204 can generate the polarized differential charging current signal 206 and the polarized differential discharging current signal 208. In such an example, the polarization module 204 can generate the polarized differential charging current signal 206 using the determined direction of the charger current 130 (e.g., the direction signal 232) to modify the differential current signal 254. The differential current signal 254 can represent and/or correspond to a leakage current of the bidirectional charging circuit 120.

At block 506, the circuitry 121 may generate a differential charging current signal and/or a differential discharging current signal. For example, the charging calculation module 210 can generate the differential charging current signal 212 using the polarized differential charging current signal 206. The discharging calculation module 214 can generate the differential discharging current signal 216 using the polarized differential discharging current signal 208.

At block 508, the circuitry 121 may determine whether differential current protection threshold(s) is/are satisfied by the current signal(s). For example, the charging trip determination module 402 can compare the differential charging current signal 212 to a first magnitude threshold and/or the time elapsed since it exceeded the first magnitude threshold to a first time elapsed threshold. In such an example, the charging trip determination module 402 can determine that at least one differential current protection threshold is satisfied when at least one of (i) the first magnitude threshold is met and/or exceeded or (ii) the first time elapsed threshold is met and/or exceeded.

By way of another example, the discharging trip determination module 406 can compare the differential discharging current signal 216 to a second magnitude threshold and/or the time elapsed since it exceeded the second magnitude threshold to a second time elapsed threshold. In such an example, the discharging trip determination module 406 can determine that at least one differential current protection threshold is satisfied when at least one of (i) the second magnitude threshold is met and/or exceeded or (ii) the second time elapsed threshold is met and/or exceeded.

If, at block 508, the circuitry 121 determines that at least one differential current protection threshold is satisfied by the current signal(s), control proceeds to block 510. Otherwise, control proceeds to block 512.

At block 510, the circuitry 121 may output a differential current protection signal to interrupt the charger current. For example, the control logic 410 can output the differential current protection signal 222 to interrupt the charger current 130 in response to the differential charging current signal 212 and/or the differential discharging current signal 216 satisfying at least one differential current protection threshold. The control logic 410 can interrupt the charger current 130 by controlling the first switch 134 using the differential current protection signal 222 such that the first switch 134 can open and thereby break the first line input 112 of FIG. 1. Additionally and/or alternatively, the control logic 410 can interrupt the charger current 130 by controlling the second switch 136 using the differential current protection signal 222 such that the second switch 136 can open and thereby break the second line input 114 of FIG. 1.

At block 512, the circuitry 121 may determine whether to continue monitoring the bidirectional charging circuit for a ground fault condition. For example, the circuitry 121 can process subsequent measurements of the charger voltage 128, the charger current 130, and/or the differential current 132 to detect whether the differential current 132 has met and/or exceeded at least one differential current protection threshold.

If, at block 512, the circuitry 121 determines to continue monitoring the bidirectional charging circuit for a ground fault condition, control returns to block 502 to restart the flowchart 500. Otherwise, the flowchart 500 of FIG. 5 concludes.

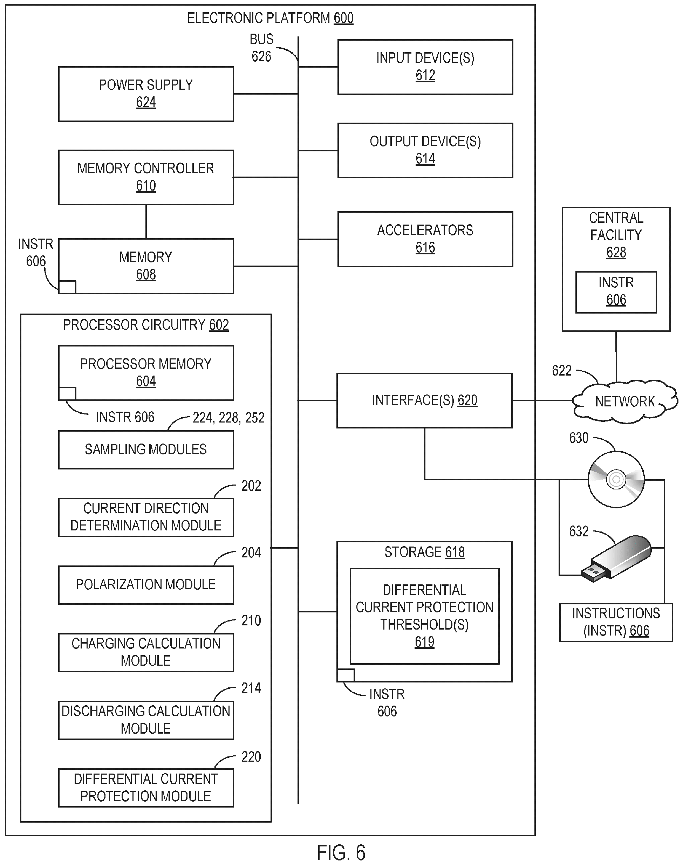

FIG. 6 is an example implementation of an electronic platform 600 structured to execute the machine-readable instructions of FIG. 5 to implement the bidirectional charging system 102 of FIG. 1, or portion(s) thereof, such as the circuitry 121 of FIGS. 1 and/or 2. It should be appreciated that FIG. 6 is intended neither to be a description of necessary components for an electronic and/or computing device to operate as a bidirectional charging system, or portion(s) thereof, in accordance with the techniques described herein, nor a comprehensive depiction.

The electronic platform 600 of this example may be a battery charging system, an EVPTS, an electric utility meter, or any other type of computing and/or electronic device. The electronic platform 600 includes processor circuitry 602, which may be implemented by one or more programmable processors, one or more hardware-implemented state machines, one or more ASICs, etc., and/or any combination(s) thereof. The processor circuitry 602 includes processor memory 604, which may be volatile memory, such as random-access memory (RAM) of any type. The processor circuitry 602 of this example implements the sampling modules 224, 228, 252, the current direction determination module 202, the polarization module 204, the charging calculation module 210, the discharging calculation module 214, and the differential current protection module 220 of FIGS. 2, 3, and/or 4.

The processor circuitry 602 may execute machine-readable instructions 606 (identified by INSTRUCTIONS), which are stored in the processor memory 604, to implement at least one of the sampling modules 224, 228, 252, the current direction determination module 202, the polarization module 204, the charging calculation module 210, the discharging calculation module 214, or the differential current protection module 220. The machine-readable instructions 606 may include data representative of computer-executable and/or machine-executable instructions implementing techniques that operate according to the techniques described herein. For example, the machine-readable instructions 606 may include data (e.g., code, embedded software (e.g., firmware), software, etc.) representative of the flowchart of FIG. 5, or portion(s) thereof.

The electronic platform 600 includes memory 608, which may include the instructions 606. The memory 608 of this example may be controlled by a memory controller 610. For example, the memory controller 610 may control reads, writes, and/or, more generally, access(es) to the memory 608 by other component(s) of the electronic platform 600. The memory 608 of this example may be implemented by volatile memory, non-volatile memory, etc., and/or any combination(s) thereof. For example, the volatile memory may include static random-access memory (SRAM), dynamic random-access memory (DRAM), cache memory (e.g., Level 1 (L1) cache memory, Level 2 (L2) cache memory, Level 3 (L3) cache memory, etc.), etc., and/or any combination(s) thereof. In some examples, the non-volatile memory may include Flash memory, electrically erasable programmable read-only memory (EEPROM), magnetoresistive random-access memory (MRAM), ferroelectric random-access memory (FeRAM, F-RAM, or FRAM), etc., and/or any combination(s) thereof.

The electronic platform 600 includes input device(s) 612 to enable data and/or commands to be entered into the processor circuitry 602. For example, the input device(s) 612 may include at least one sensor, such as the voltage sensor 122, the current sensor 124, and/or the differential current sensor 126 of FIG. 1.

The electronic platform 600 includes output device(s) 614 to convey, display, and/or present information to a user (e.g., a human user, a machine user, etc.). For example, the output device(s) 614 may include one or more display devices, speakers, etc. The one or more display devices may include an augmented reality (AR) and/or virtual reality (VR) display, a liquid crystal display (LCD), a light-emitting diode (LED) display, an organic light-emitting diode (OLED) display, a quantum dot (QLED) display, a thin-film transistor (TFT) LCD, a touchscreen, etc., and/or any combination(s) thereof.

The electronic platform 600 includes accelerators 616, which are hardware devices to which the processor circuitry 602 may offload compute tasks to accelerate their processing. For example, the accelerators 616 may include artificial intelligence/machine-learning (AI/ML) processors, ASICs, FPGAs, graphics processing units (GPUs), neural network (NN) processors, systems-on-chip (SoCs), vision processing units (VPUs), etc., and/or any combination(s) thereof. In some embodiments, one or more modules of the processor circuitry 602 may be implemented by one(s) of the accelerators 616 instead of the processor circuitry 602. In some examples, one or more modules of the processor circuitry 602 may be executed concurrently (e.g., in parallel, substantially in parallel, etc.) by the processor circuitry 602 and the accelerators 616.

The electronic platform 600 includes storage 618 to record and/or control access to data, such as the machine-readable instructions 606. In this example, the storage 618 can store differential current protection threshold(s) 619. The differential current protection threshold(s) 619 can include the first magnitude threshold, the second magnitude threshold, the first time elapsed threshold, and/or the second time elapsed threshold. The storage 618 may be implemented by one or more mass storage disks or devices, such as HDDs, SSDs, etc., and/or any combination(s) thereof.

The electronic platform 600 includes interface(s) 620 to effectuate exchange of data with external devices (e.g., computing and/or electronic devices of any kind) via a network 622. The interface(s) 620 of the illustrated example may be implemented by an interface device, such as network interface circuitry (e.g., a NIC, a smart NIC, etc.), a gateway, a router, a switch, etc., and/or any combination(s) thereof. The interface(s) 620 may implement any type of communication interface, such as BLUETOOTH^{®}, a cellular telephone system (e.g., a 4G LTE interface, a 5G interface, a future generation 6G interface, etc.), an Ethernet interface, a near-field communication (NFC) interface, an optical fiber interface, a satellite interface, a Universal Serial Bus (USB) interface (e.g., USB Type-A, USB Type-B, USB TYPE-C^{™} or USB-C^{™}, etc.), etc., and/or any combination(s) thereof.

The electronic platform 600 includes a power supply 624 to store energy and provide power to components of the electronic platform 600. The power supply 624 may be implemented by a power converter, such as an AC/DC power converter, a DC/DC power converter, etc., and/or any combination(s) thereof. For example, the power supply 624 may be powered by an external power source, such as an AC power source (e.g., an electrical grid), a DC power source (e.g., a battery, a battery backup system, etc.), etc., and the power supply 624 may convert the AC input or the DC input into a suitable voltage for use by the electronic platform 600. In some examples, the power supply 624 may be a limited duration power source, such as a battery (e.g., a rechargeable battery such as a lithium-ion battery).

Component(s) of the electronic platform 600 may be in communication with one(s) of each other via a bus 626. For example, the bus 626 may be any type of computing and/or electrical bus, such as an inter-integrated circuit (I2C) bus, a peripheral component interconnect (PCI) bus, a peripheral component interconnect express (PCIe) bus, a serial peripheral interface (SPI) bus, a universal chiplet interconnect express (UCIe) bus, and/or the like.

The network 622 may be implemented by any wired and/or wireless network(s) such as one or more cellular networks (e.g., 4G LTE cellular networks, 5G cellular networks, future generation 6G cellular networks, etc.), one or more local area networks (LANs), one or more optical fiber networks, one or more private networks, one or more public networks, one or more wireless local area networks (WLANs), etc., and/or any combination(s) thereof. For example, the network 622 may be the Internet.

The network 622 of the illustrated example facilitates communication between the interface(s) 620 and a central facility 628. The central facility 628 in this example may be an entity associated with one or more servers, such as one or more physical hardware servers and/or virtualizations of the one or more physical hardware servers. For example, the central facility 628 may be implemented by a public cloud provider, a private cloud provider, etc., and/or any combination(s) thereof. In this example, the central facility 628 may compile, generate, update, etc., the machine-readable instructions 606 and store the machine-readable instructions 606 for access (e.g., download) via the network 622. For example, the electronic platform 600 may transmit a request, via the interface(s) 620, to the central facility 628 for the machine-readable instructions 606 and receive the machine-readable instructions 606 from the central facility 628 via the network 622 in response to the request.

Additionally or alternatively, the interface(s) 620 may receive the machine-readable instructions 606 via non-transitory machine-readable storage media, such as an optical disc 630 (e.g., a Blu-ray disc, a CD, a DVD, etc.) or any other type of removable non-transitory machine-readable storage media such as a USB drive 632. For example, the optical disc 630 and/or the USB drive 632 may store the machine-readable instructions 606 thereon and provide the machine-readable instructions 606 to the electronic platform 600 via the interface(s) 620.

Techniques operating according to the principles described herein may be implemented in any suitable manner. The processing and decision blocks of the flowcharts above represent steps and acts that may be included in algorithms that carry out these various processes. Algorithms derived from these processes may be implemented as software integrated with and directing the operation of one or more single- or multi-purpose processors, may be implemented as functionally equivalent circuits such as a DSP circuit or an ASIC, or may be implemented in any other suitable manner. It should be appreciated that the flowcharts included herein do not depict the syntax or operation of any particular circuit or of any particular programming language or type of programming language. Rather, the flowcharts illustrate the functional information one skilled in the art may use to fabricate circuits or to implement computer software algorithms to perform the processing of a particular apparatus carrying out the types of techniques described herein. For example, the flowcharts, or portion(s) thereof, may be implemented by hardware alone (e.g., one or more analog or digital circuits, one or more hardware-implemented state machines, etc., and/or any combination(s) thereof) that is configured or structured to carry out the various processes of the flowcharts. In some examples, the flowcharts, or portion(s) thereof, may be implemented by machine-executable instructions (e.g., machine-readable instructions, computer-readable instructions, computer-executable instructions, etc.) that, when executed by one or more single- or multi-purpose processors, carry out the various processes of the flowcharts. It should also be appreciated that, unless otherwise indicated herein, the particular sequence of steps and/or acts described in each flowchart is merely illustrative of the algorithms that may be implemented and can be varied in implementations and embodiments of the principles described herein.

Accordingly, in some embodiments, the techniques described herein may be embodied in machine-executable instructions implemented as software, including as application software, system software, firmware, middleware, embedded code, or any other suitable type of computer code. Such machine-executable instructions may be generated, written, etc., using any of a number of suitable programming languages and/or programming or scripting tools, and also may be compiled as executable machine language code or intermediate code that is executed on a framework, virtual machine, or container.

Machine-executable instructions (e.g., processor-executable instructions) implementing the techniques described herein (when implemented as one or more functional facilities or in any other manner) may, in some embodiments, be encoded on one or more computer-readable media, machine-readable media, etc., to provide functionality to the media. Computer-readable media, machine-readable media, etc., include magnetic media such as a hard disk drive, optical media such as a CD or a DVD, a persistent or non-persistent solid-state memory (e.g., Flash memory, Magnetic RAM, etc.), or any other suitable storage media. Such a computer-readable medium, a machine-readable medium, etc., may be implemented in any suitable manner. As used herein, the terms "computer-readable media" (also called "computer-readable storage media"), "computer-readable medium" (also called "computer-readable storage medium"), "machine-readable media" (also called "machine-readable storage media"), and "machine-readable medium" (also called "machine-readable storage medium") refer to tangible storage media. Tangible storage media are non-transitory and have at least one physical, structural component. In a "computer-readable medium" and "machine-readable medium" as used herein, at least one physical, structural component has at least one physical property that may be altered in some way during a process of creating the medium with embedded information, a process of recording information thereon, or any other process of encoding the medium with information. For example, a magnetization state of a portion of a physical structure of a computer-readable medium, a machine-readable medium, etc., may be altered during a recording process.

Embodiments have been described where the techniques are implemented in circuitry and/or machine-executable instructions. It should be appreciated that some embodiments may be in the form of a method, of which at least one example has been provided. The acts performed as part of the method may be ordered in any suitable way. Accordingly, embodiments may be constructed in which acts are performed in an order different than illustrated, which may include performing some acts simultaneously, even though shown as sequential acts in illustrative embodiments.

Various aspects of the embodiments described above may be used alone, in combination, or in a variety of arrangements not specifically discussed in the embodiments described in the foregoing and is therefore not limited in its application to the details and arrangement of components set forth in the foregoing description or illustrated in the drawings. For example, aspects described in one embodiment may be combined in any manner with aspects described in other embodiments.

The phrase "and/or," as used herein in the specification and in the claims, should be understood to mean "either or both," of the elements so conjoined, e.g., elements that are conjunctively present in some cases and disjunctively present in other cases. Multiple elements listed with "and/or" should be construed in the same fashion, e.g., "one or more" of the elements so conjoined. Other elements may optionally be present other than the elements specifically identified by the "and/or" clause, whether related or unrelated to those elements specifically identified. Thus, as a non-limiting example, a reference to "A and/or B," when used in conjunction with open-ended language such as "comprising" can refer, in one embodiment, to A only (optionally including elements other than B); in another embodiment, to B only (optionally including elements other than A); in yet another embodiment, to both A and B (optionally including other elements); etc.

The indefinite articles "a" and "an," as used herein in the specification and in the claims, unless clearly indicated to the contrary, should be understood to mean "at least one."

As used herein in the specification and in the claims, the phrase, "at least one," in reference to a list of one or more elements, should be understood to mean at least one element selected from any one or more of the elements in the list of elements, but not necessarily including at least one of each and every element specifically listed within the list of elements and not excluding any combinations of elements in the list of elements. This definition also allows that elements may optionally be present other than the elements specifically identified within the list of elements to which the phrase "at least one" refers, whether related or unrelated to those elements specifically identified. Thus, as a non-limiting example, "at least one of A and B" (or, equivalently, "at least one of A or B," or, equivalently, "at least one of A and/or B") can refer, in one embodiment, to at least one, optionally including more than one, A, with no B present (and optionally including elements other than B); in another embodiment, to at least one, optionally including more than one, B, with no A present (and optionally including elements other than A); in yet another embodiment, to at least one, optionally including more than one, A, and at least one, optionally including more than one, B (and optionally including other elements); etc.

Use of ordinal terms such as "first," "second," "third," etc., in the claims to modify a claim element does not by itself connote any priority, precedence, or order of one claim element over another or the temporal order in which acts of a method are performed, but are used merely as labels to distinguish one claim element having a certain name from another element having a same name (but for use of the ordinal term) to distinguish the claim elements.

Also, the phraseology and terminology used herein is for the purpose of description and should not be regarded as limiting. The use of "including," "comprising," "having," "containing," "involving," and variations thereof herein, is meant to encompass the items listed thereafter and equivalents thereof as well as additional items.

All definitions, as defined and used herein, should be understood to control over dictionary definitions, definitions in documents incorporated by reference, and/or ordinary meanings of the defined terms.

Having thus described several aspects of at least one embodiment, it is to be appreciated that various alterations, modifications, and improvements will readily occur to those skilled in the art. Such alterations, modifications, and improvements are intended to be part of this disclosure and are intended to be within the spirit and scope of the principles described herein. Accordingly, the foregoing description and drawings are by way of example only.

## Claims

1. A method for bidirectional differential current protection in a bidirectional charging circuit for charging and/or discharging a battery of a vehicle, the method comprising:
using circuitry to perform:
determining a direction of charger current flowing through the bidirectional charging circuit coupled to the battery of the vehicle;
generating at least one polarized differential current signal using the determined direction of the charger current to modify a differential current signal representing a leakage current of the bidirectional charging circuit;
generating a differential charging current signal and/or a differential discharging current signal using the at least one polarized differential current signal; and
outputting a differential current protection signal to interrupt the charger current in response to the differential charging current signal and/or the differential discharging current signal satisfying at least one threshold.

2. The method of claim 1, further comprising controlling a switch with the differential current protection signal to interrupt the current flowing through the bidirectional charging circuit.

3. The method of claim 1 or 2, wherein determining the direction of the current flow comprises:
generating a charger voltage signal corresponding to a charger voltage of a first alternating current (AC) line input with respect to a second AC line input or an AC neutral input; and
generating a filtered charger voltage signal by filtering the charger voltage signal at a reference utility voltage frequency.

4. The method of claim 3, wherein determining the direction of the current flow comprises:
generating a charger current signal corresponding to the charger current flowing through the first AC line input; and
generating a filtered charger current signal by filtering the charger current signal at the reference utility voltage frequency.

5. The method of claim 4, wherein determining the direction of the current flow comprises:
normalizing the filtered charger voltage signal to generate a normalized charger voltage signal;
normalizing the filtered charger current signal to generate a normalized charger current signal; and
determining a direction signal using the normalized charger voltage signal and the normalized charger current signal, the direction signal indicative of whether the direction of the charger current is in phase or out of phase with respect to the charger voltage.

6. The method of claim 5, wherein determining the direction of the current flow comprises:
determining that the direction signal indicates that the charger current is in phase with respect to the charger voltage; and
determining that the bidirectional charging circuit is operating in a charging mode when the charger current is in phase with respect to the charger voltage, the charging mode corresponding to the charger current flowing from a power source external to the vehicle to the battery;
or,
wherein determining the direction of the current comprises:
determining that the direction signal indicates that the charger current is out of phase with respect to the charger voltage; and
determining that the bidirectional charging circuit is operating in a discharging mode when the charger current is out of phase with respect to the charger voltage, the discharging mode corresponding to the charger current flowing from the battery to a load external to the vehicle.

7. The method of any preceding claim, wherein outputting the differential current protection signal comprises:
comparing a first magnitude of the differential charging current signal to a first magnitude threshold;
comparing a second magnitude of the differential discharging current signal to a second magnitude threshold different from the first magnitude threshold; and
outputting the differential current protection signal to a switch in response to at least one of (i) the first magnitude satisfying the first magnitude threshold or (ii) the second magnitude satisfying the second magnitude threshold.

8. The method of any preceding claim, wherein outputting the differential current protection signal comprises:
comparing, using an inverse time trip curve, (i) an elapsed time since a magnitude of at least one of the differential charging current signal or the differential discharging current signal satisfied a respective different magnitude threshold to (ii) an elapsed time threshold; and
outputting the differential current protection signal to a switch in response to the elapsed time satisfying the elapsed time threshold.

9. The method of any preceding claim, wherein the vehicle is a battery electric vehicle, a plug-in hybrid electric vehicle, or a hybrid electric vehicle.

10. At least one computer-readable storage medium storing processor executable instructions that, when executed by at least one hardware processor, cause the at least one hardware processor to perform a method for bidirectional differential current protection in a bidirectional charging circuit for charging and/or discharging a battery of a vehicle, the method comprising:
determining a direction of charger current flowing through the bidirectional charging circuit coupled to the battery of the vehicle;
generating at least one polarized differential current signal using the determined direction of the charger current to modify a differential current signal representing a leakage current of the bidirectional charging circuit;
generating a differential charging current signal and/or a differential discharging current signal using the at least one polarized differential current signal; and
outputting a differential current protection signal to interrupt the charger current in response to the differential charging current signal and/or the differential discharging current signal satisfying at least one threshold.

11. The at least one computer-readable storage medium of claim 10, the method further comprising controlling a switch with the differential current protection signal to interrupt the current flowing through the bidirectional charging circuit;
and/or,
wherein outputting the differential current protection signal comprises:
comparing a first magnitude of the differential charging current signal to a first magnitude threshold;
comparing a second magnitude of the differential discharging current signal to a second magnitude threshold different from the first magnitude threshold; and
outputting the differential current protection signal to a switch in response to at least one of (i) the first magnitude satisfying the first magnitude threshold or (ii) the second magnitude satisfying the second magnitude threshold;
and/or,
wherein outputting the differential current protection signal comprises:
comparing (i) an elapsed time since a magnitude of at least one of the differential charging current signal or the differential discharging current signal satisfied a respective different magnitude threshold to (ii) an elapsed time threshold; and
outputting the differential current protection signal to a switch in response to the elapsed time satisfying the elapsed time threshold.

12. A bidirectional charging system for charging and/or discharging a battery of a vehicle, the system comprising:
a differential current sensor configured to measure a differential current signal associated with charging and/or discharging the battery of the vehicle; and
bidirectional charging circuitry coupled to the differential current sensor and configured to:
determine a direction of charger current flowing through the bidirectional charging circuitry coupled to the battery of the vehicle;
generate at least one polarized differential current signal using the determined direction of the charger current to modify a differential current signal representing a leakage current of the bidirectional charging circuit;
generate a differential charging current signal and/or a differential discharging current signal using the at least one polarized differential current signal; and
output a differential current protection signal to interrupt the charger current in response to the differential charging current signal and/or the differential discharging current signal satisfying at least one threshold.

13. The bidirectional charging system of claim 12, further comprising a switch in circuit with a line input coupled to the battery, and the bidirectional charging circuitry is configured to control the switch with the differential current protection signal to interrupt the current flowing through the line input;
and/or,
further comprising:
a voltage sensor configured to measure a charger voltage signal corresponding to a charger voltage of a first alternating current (AC) line input with respect to a second AC line input or an AC neutral input, and wherein determining the direction of the current flow comprises:
generating a filtered charger voltage signal by filtering the charger voltage signal at a reference utility voltage frequency.

14. The bidirectional charging system of claim 13, further comprising:
a current sensor configured to measure a charger current signal corresponding to the charger current flowing through the first AC line input, and wherein determining the direction of the current flow comprises:
generating a filtered charger current signal by filtering the charger current signal at the reference utility voltage frequency.

15. The bidirectional charging system of claim 14, wherein determining the direction of the current flow comprises:
determining, using the charger voltage signal, that the direction signal indicates that the charger current is in phase with respect to the charger voltage; and
determining that the bidirectional charging circuit is operating in a charging mode when the charger current is in phase with respect to the charger voltage, the charging mode corresponding to the charger current flowing from a power source external to the vehicle to the battery;
or,
wherein determining the direction of the current comprises:
determining, using the charger current signal, that the direction signal indicates that the charger current is out of phase with respect to the charger voltage; and
determining that the bidirectional charging circuit is operating in a discharging mode when the charger current is out of phase with respect to the charger voltage, the discharging mode corresponding to the charger current flowing from the battery to a load external to the vehicle.
